# EUROPEAN PATENT APPLICATION

(11) **EP 1 220 225 A1**
(43) Date of publication of application: **03.07.2002**
(21) Application number: 00830855.3
(22) Date of filing: 28.12.2000
(51) Int. Cl.: G11C 7/10, G11C 16/26

(54) **Method and device for reducing the mean access time to a non volatile memory during the reading phase**

(71) Applicant: STMicroelectronics S.r.l., 20041 Agrate Brianza (Milano) (IT)
(72) Inventor: Riva Reggiori, Riccardo, 20090 Milano 2 Segrate (Milano) (IT); Schippers, Stefan, 37019 Peschiera del Garda (Verona) (IT); Sali, Mauro, 26886 S. Angelo Lodigiano (Lodi) (IT)
(74) Representative: Botti, Mario

(57) **Abstract**

The invention relates to a method and a device for reducing the average access time of a non-volatile memory during the reading phase, whereby a reading is effected, in either the page mode or the burst mode, from a matrix array (2) of memory cells to which a logic for recognizing access addresses to the memory is associated. The method is characterized by:
providing a buffer memory (4) associated with the cell matrix array (2), and
storing a predetermined number (n) of memory words into the buffer memory (4) subsequently to a last-effected reading of the cell matrix array (2).

## Description

### Field of Application

This invention relates to a method for reducing the average access time of a non-volatile memory during the reading phase.

In particular, the invention relates to a method whereby the reading phase is effected, in either the page or the burst mode, from a matrix array of memory cells with which a logic for recognizing access addresses to the memory is associated.

The invention also relates to a memory device implementing the inventive method.

The invention relates, particularly but not exclusively, to Flash EEPROM electronic devices integrated in a semiconductor, and the following description is made with reference to this application field for convenience of illustration only.

### Prior Art

As it is well known, in this particular technical field new modes of reading non-volatile memory devices are needed to be provided, in order to fill a firm market demand for improved reading performance.

Recently new reading modes have already been introduced which were tested and used with other types of memory devices, such as volatile DRAMs and SRAMs.

One of these new methods is known as the page reading mode, whereby a memory is read by full pages containing a varying number of memory words.

Another known reading mode is the burst mode, whereby memory words are synchronously read from consecutive locations, according to a clock signal which is provided from the outside of the memory device and can be adjusted by the user.

In either of these read modes, a time period of initial latency has to be waited before the memory can be accessed. This latency time is due to the set up phase of the memory device.

A user usually accesses a limited number of words at the time, e.g. one, two, four, eight, or sixteen words. This implies of necessity a latency time.

To better illustrate this point, two examples of reading effected in the page mode and the burst mode are reported in the following chart, for the reading of four consecutive words:

| MODE | Tacc word 1 | Tacc word 2 | Tacc word 3 | Tacc word 4 | Tacc Average | Latency |
|---|---|---|---|---|---|---|
| Page | 100ns | 35ns | 35ns | 35ns | 51.25ns | 65ns |
| Burst | 100ns | 25ns | 25ns | 25ns | 43.75ns | 75ns |

It can be seen from the above chart that the initial latency time makes the access time Tacc worse in the page mode, from a potential 35ns to an average access 51.25ns.

The initial latency time likewise deteriorates the access time Tacc in the burst mode, from a potential 25ns to an average access 43.75ns.

A way to obviate this could be that of increasing the depth of a page being read in the page mode, or increasing the number of words being sequentially read in the burst mode, that is, the number of words simultaneously read in parallel.

Shown in the following chart are the average access times at increasing page depths in the page mode:

| DEPTH | Tacc 1^{st} word | Tacc Steady state | Tacc Avarage |
|---|---|---|---|
| 2 words | 100ns | 35ns | 67.5ns |
| 4 words | 100ns | 35ns | 51.25ns |
| 8 words | 100ns | 35ns | 43.125ns |
| 16 words | 100 ns | 35ns | 39.0625ns |

The chart here below shows the average access times at increasing burst depths, in the burst mode:

| DEPTH | Tacc 1^{st} word | Tacc Steady state | Tacc Avarage |
|---|---|---|---|
| 2 words | 100ns | 25ns | 62.5ns |
| 4 words | 100ns | 25ns | 43.75ns |
| 8 words | 100ns | 25ns | 34.375ns |
| 16 words | 100 ns | 25ns | 29.6875ns |

The technical problem at the basis of the present invention is to provide a new reading mode, as well as a memory device to which such new mode can be applied, which method and device have functional and structural features effective to shorten the average access time of a non-volatile memory by substantially suppressing the initial time of latency, thereby overcoming the limitations of the prior art.

### Summary of the Invention

The solution idea at the basis of the present invention consists of using a buffer memory to store up a predetermined number of words subsequent to the last-effected reading.

Thus, the buffer memory can be used as an access predictor observing the sequential order of the readings.

The technical problem has been solved, on the basis of the above solution idea, by a method as previously indicated and defined in the characterizing portion of Claim 1.

The invention further relates to a memory device for implementing the inventive method, as defined in Claims 6 foll..

The features and advantages of the method and the memory device according to the invention will be apparent from the following description, of an embodiment thereof, given by way of example and not of limitation with reference to the accompanying drawings.

In the drawings:

### Brief Description of the Drawings

- Figure 1 shows a schematic view of a memory device embodying this invention.
- Figure 2 shows a comparative graph of access time plotted against reading depth between a conventional device and the device of this invention, in the page mode.
- Figure 3 shows a comparative graph of access time plotted against reading depth, between a conventional device and the device of this invention, in the burst mode.

### Detailed Description

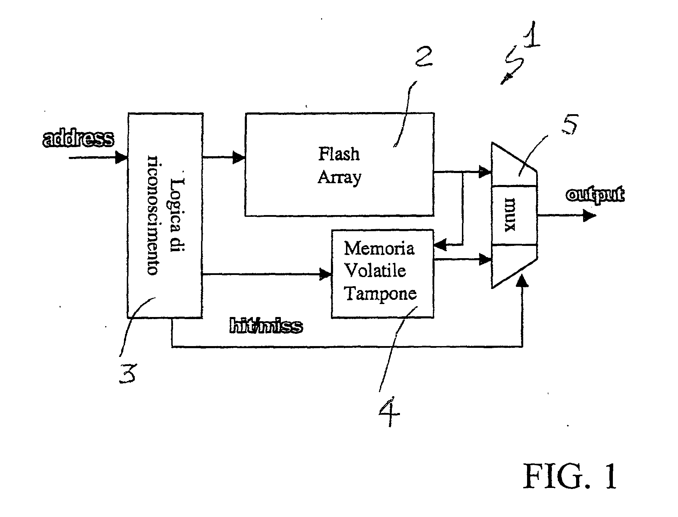

With reference to the drawings, in particular to the example of Figure 1, an electronic memory device to reduce the access time of the memory during the reading phase, according to this invention, is generally shown at 1 in schematic form.

The device 1 is essentially an integrated non-volatile memory circuit, preferably but not solely of the Flash EEPROM type, and comprises a matrix array 2 of memory cells structured in rows and columns.

Conventionally associated with the matrix array 2 is a row and column decoding circuitry 3, indicated as a "recognition logic" in Figure 1. Such circuitry is input matrix array address signals, and is arranged to select memory locations which a user may wish to access.

Advantageously in this invention, a high-speed buffer memory 4 is associated with the memory matrix array 2, which buffer memory has inputs connected to respective outputs of the matrix array 2.

The buffer memory 4 is preferably of the volatile memory type, specifically of the SRAM type.

This memory 4 can contain a number n of memory words, with the number n being set by the user.

Advantageously, the number n is a function of the time lapse separating two successive accesses to the memory matrix array 2. The number n is also function of the average power consumption sought by the user in the standby condition, as explained hereinafter.

The buffer memory 4 is connected in its turn to the recognition circuitry 3.

The basic structure of the device 1 according to the invention is completed by a multiplexer 5, which multiplexer is input the outputs from the non-volatile memory matrix array 2, the outputs from the buffer memory 4, and further outputs from the recognition logic 3.

A non-volatile memory device provided with a cache memory is disclosed in the US Patent No. 5,726,937 in the name of Norand Corporation. That patent teaches the use of a SRAM as a write buffer memory wherein a microprocessor writes a data packet with high throughput. The data written in the SRAM are then written into the non-volatile memory as background.

On the other hand, the buffer memory 4 of this invention is expressly intended for the reading phase, and is essentially used to be ready for the next reading to the last-effected one, so as to suppress the latency time.

The method of accessing the memory according to the invention will now be described.

The buffer memory 4 is used to store up one to n successive memory words relating to the last-effected reading.

Subsequent accesses to memory locations in the buffer memory 4 will have zero latency times, hereinafter referred to as "hits".

The loading of the buffer memory 4 takes place with the memory matrix array 2 in the idle (non-selected) state, and starts from the last-read location of the matrix array 2.

The readings which allow the data to be retrieved for storing into the buffer memory 4 may be managed directly from the inside of the device 1, or be timed by a clock provided by the user from the outside and that synchronizes all the reading phases.

Advantageously in this invention, accesses to locations of the memory matrix array 2 which do not appear in the buffer memory 4 will be burdened with no access time because a new reading phase from the memory matrix array 2 is started for them in parallel to the reading of the buffer memory 4. In this case, the buffer memory 4 would be reset and a new loading phase initiated.

The number n of words contained in the buffer memory 4 is a function of the longest jump, from the location last-accessed for reading, that the user is allowed to make with no initial latency period.

This number n may be a configurable parameter by the user, according to the performance level sought in terms of power consumption and speed.

The following chart shows average read access times against hit percent, i.e. against accesses which produce zero latency time. The chart reflects the assumption of four memory words being read.

| | Tacc ave. Standard Mem. | Tacc max | Tacc New Method | Remarks |
|---|---|---|---|---|
| 50% hits | | | | |
| Page mode | 51.25ns | 35ns | 43.125ns | |
| Burst Mode 40MHz | 43.75ns | 25ns | 34.375ns | < burst for eight words |
| 80% hits | | | | |
| Page Mode | 51.25ns | 35ns | 38.25ns | |
| Burst Mode 40 Mhz | 43075 | 25ns | 28.75ns | < burst for sixteen |

It can be seen from this chart that, for a four-word reading at 50% hits in the burst mode, the method of this invention provides better average read access times than could be obtained with an eight-word deep burst mode.

Similarly for a four-word reading at 80% hits in the burst mode, the inventive method provides better average read access times than could be obtained with a sixteen-word deep burst mode.

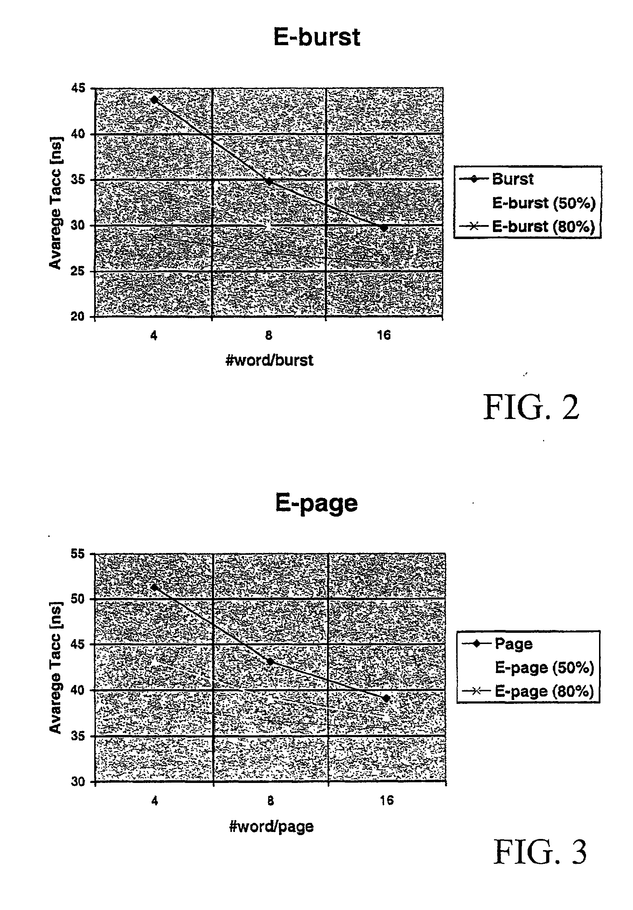

The comparative graphs of Figures 2 and 3 schematically illustrate the access times obtained by the method of this invention and they are compared with those obtained by other reading modes on devices not incorporating a buffer memory 4.

It should be further noted that the buffer memory 4 is directed to read the matrix array 2 primarily by sequential accesses.

It can be appreciated from the foregoing that the method and memory device of this invention do solve the technical problem and achieve brilliant overall results in respect of the read access time to a non-volatile memory.

## Claims

1. A method for reducing the average time of accessing a non-volatile memory during the reading phase, whereby a reading is effected, in either the page mode or the burst mode, from a matrix array (2) of memory cells to which a logic for recognizing access addresses to the memory is associated, **characterized by**:
providing a buffer memory (4) associated with the cell matrix array (2), and
storing a predetermined number (n) of memory words into said buffer memory (4) subsequently to a last-effected reading of the cell matrix array (2).

2. A method according to Claim 1, **characterized in that** the reading of the non-volatile memory matrix array (2) is effected with said memory matrix array in the idle or non-selected condition.

3. A method according to Claim 1, **characterized in that** said predetermined number (n) of memory words can be set by a user.

4. A method according to Claim 1, **characterized in that** said number (n) is a function of the average power consumption sought for the standby condition, as well as of an average time lapse between consecutive accesses to said memory matrix array (2).

5. A method according to Claim 1, **characterized in that** each new reading phase of said memory matrix array (2) is effected in parallel to a reading phase of said buffer memory (2), limited for those locations of said memory matrix array (2) which do not appear in said buffer memory (4), said new reading phase being effected so as to have said buffer memory (4) reset and re-loaded.

6. An electronic memory device having reduced reading access time requirements, said device comprising a matrix array (2) of non-volatile memory cells adapted to be read in either the page mode or the burst mode, and comprising associated recognition logic (3) for recognizing memory access addresses, **characterized in that** it comprises a buffer memory (4) associated with the cell matrix array (2) and adapted to store up a predetermined number (n) of memory words subsequently to every last-effected reading of the cell matrix array (2).

7. A device according to Claim 6, **characterized in that** said buffer memory (4) is a SRAM.

8. A device according to Claim 6, **characterized in that** the number (n) of memory words contained in the buffer memory (4) can be set by a user.
